# EUROPEAN PATENT APPLICATION

(11) **EP 4 645 356 A1**
(43) Date of publication of application: **05.11.2025**
(21) Application number: 25172425.8
(22) Date of filing: 24.04.2025
(51) Int. Cl.: H01G 4/012, H01G 4/33, H01G 4/005, H10D 1/68, H01G 4/018, H01G 4/06

(54) **HIGH VOLTAGE CAPACITANCE DEVICE**

(30) Priority: 01.05.2024 US 202418652502
(71) Applicant: NXP B.V., 5656 AG Eindhoven (NL)
(72) Inventor: Ooms, Eric, 5656AG Eindhoven (NL); Bruggers, Herman Jan, 5656AG Eindhoven (NL); Duan, Ning, 5656AG Eindhoven (NL); Sque, Stephen John, 5656AG Eindhoven (NL)
(74) Representative: Krott, Michel

(57) **Abstract**

One example discloses a capacitance device, including: a substrate; a bottom-plate coupled to the substrate; an insulator coupled to the bottom-plate; and a top-plate coupled to the insulator; wherein the top-plate includes a flat portion and a curved portion.

## Description

The present specification relates to systems, methods, apparatuses, devices, and articles of manufacture for high voltage capacitance applications such as galvanic isolation, energy storage in electric circuits.

### SUMMARY

According to an example embodiment, a capacitance device, comprising: a substrate; a bottom-plate coupled to the substrate; an insulator coupled to the bottom-plate; and a top-plate coupled to the insulator; wherein the top-plate includes a flat portion and a curved portion.

In another example embodiment, the substrate is a semiconductor or an insulator.

In another example embodiment, the curved portion of the top-plate is at a first end of the flat portion of the top-plate.

In another example embodiment, the curved portion of the top-plate is also at a second end of the flat portion of the top-plate.

In another example embodiment, the curved portion of the top-plate surrounds the flat portion of the top-plate.

In another example embodiment, the flat portion of the top-plate starts at a center of the top-plate and ends at the curved portion of the top-plate.

In another example embodiment, the curved portion of the top-plate includes an upwards curved portion.

In another example embodiment, the upwards curved portion is at a predetermined distance from the center of the top-plate.

In another example embodiment, the upwards curved portion defines a bend in the top-plate.

In another example embodiment, the flat portion of the top-plate is at a first distance from the bottom-plate; and the curved portion of the top-plate is at a second distance from the bottom-plate.

In another example embodiment, the second distance is greater than the first distance.

In another example embodiment, the insulator has, a first thickness under the flat portion of the top-plate; and a second thickness under the curved portion of the top-plate.

In another example embodiment, the bottom-plate includes a first end, a middle area, and a second end; and the first end is at one side of the middle area and the second end is at another side of the middle area.

In another example embodiment, the insulator includes a first insulator portion at the first end of the bottom-plate; and the insulator also includes a second insulator portion that overlays the first insulator portion, the first end, the middle area, and the second end of the bottom-plate.

In another example embodiment, the first insulator portion is also at the second end of the bottom-plate.

In another example embodiment, the first insulator portion only overlays the first end and the second end of the bottom-plate.

In another example embodiment, the first insulator portion is fabricated from a first dielectric material, and the second insulator portion is fabricated from a second dielectric material that is different from the first dielectric material.

In another example embodiment, the insulator includes a first insulator portion that overlays the first end, the middle area, and the second end of the bottom-plate; and the insulator also includes a second insulator portion that overlays the first insulator portion and the first end of the bottom-plate.

In another example embodiment, the second insulator portion also overlays the second end of the bottom-plate.

In another example embodiment, the second insulator portion only overlays the first end and the second end of the bottom-plate.

In another example embodiment, all edges of the top plate overhang the bottom plate.

In another example embodiment, further including an additional dielectric material at both ends of the top-plate, and in contact with the insulator.

The above discussion is not intended to represent every example embodiment or every implementation within the scope of the current or future Claim sets. The Figures and Detailed Description that follow also exemplify various example embodiments.

Various example embodiments may be more completely understood in consideration of the following Detailed Description in connection with the accompanying Drawings.

### BRIEF DESCRIPTION OF THE DRAWINGS

Figure 1 represents an example of a prior art capacitor.
Figure 2 represents a first example of a capacitance device having a curved topology.
Figures 3A, 3B, 3C, 3D, 3E, 3F, 3G, 3H represent an example set of steps for fabricating the first example capacitance device.
Figure 4 represents a second example of the capacitance device having a curved topology.
Figures 5A, 5B, 5C represent an example set of simulations comparing the prior art capacitor with the example capacitance devices.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

### DETAILED DESCRIPTION

Capacitive structures are used to shape signals, block noise, isolate circuits, as well as for many other functions. In some applications, such capacitive structures prevent electrical and magnetic interference or noise between the high voltage and low voltage domains in a system, while still allowing the signal and power transfer between these domains. Note, example voltages can be 10V, 1kV, or and voltage lower or higher depending on the application.

For reference, capacitance(C) between two parallel plates is given as C=ε₀εᵣA/d, where: C is capacitance, in Farads; A is an overlapping area of two plates in square meters; d is a distance between the plates in meters; ε₀ constant is the permittivity of free space; and εᵣ is the relative permittivity of an insulator between the two plates.

The high voltage isolation performance of the capacitive structures is dependent on the thickness of the insulating material and the top plate edge profile.

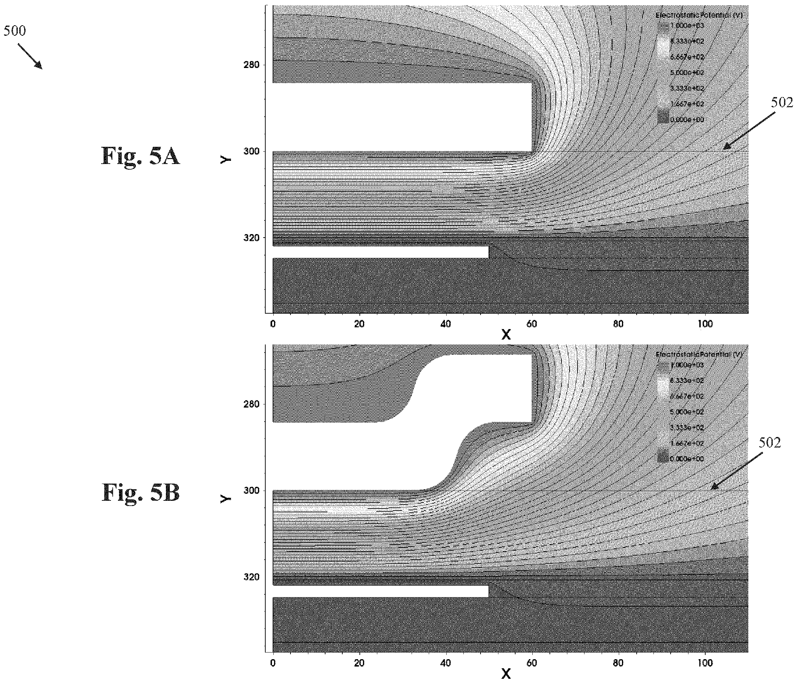

Time-dependent dielectric breakdown (TDDB) is a characterization of a capacitor's dielectric breakdown caused by formation of a conducting path through the capacitor's insulator region. TDDB may be affected by capacitor aging and/or applied voltage and leads to dielectric breakdown typically at edges of the top-plate due to the top-plate's sharp corners that concentrate electrostatic potential contours, resulting in high E-fields (see Figure 5A).

While a thicker insulating layer provides higher voltage isolation and high voltage breakdown performance, such thicker insulators decrease the capacitance and such lower capacitance can negatively affect a device's functional performance.

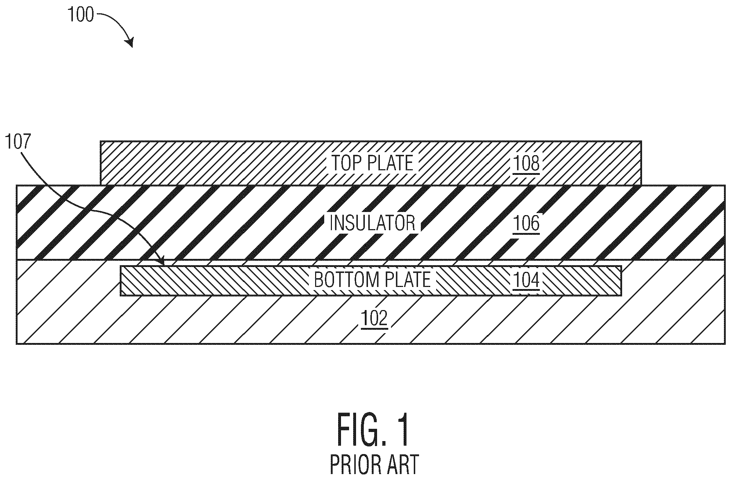

Figure 1 represents an example 100 of a prior art capacitor. The capacitor 100 includes a substrate 102, a bottom-plate 104, an insulator 106, and a flat top-plate 108. The capacitance (C) of this structure depends dimensions and positioning of the bottom-plate 104, the insulator 106, and the flat top-plate 108 as defined by the capacitance (C) equation above for two-plate capacitors. The capacitor 100 may also include an additional insulating layer 107 (e.g., passivation layer) immediately on top of the bottom plate 104.

The flat top-plate 108 has a sharp edge profile resulting in a concentrated E-field at the sharp corners during operation and thus a lower dielectric breakdown voltage at the sharp corners.

Now discussed is a capacitance device having a curved topology for either or both a top-plate and/or a bottom-plate 204. The curved portions are in many example embodiments at one or both ends of these plates. The curved portions increase a dielectric breakdown voltage of the capacitance device, while otherwise maintaining the capacitance device's operational parameters (e.g. capacitance (C)). The curved portions position the sharp edges from either or both of the plates to a thickest insulator.

While the example embodiments discussed below apply the curved topology to a top-plate of a capacitance device, such as a capacitor, there are other possible example embodiments that apply the same or similar curved topologies to a bottom-plate 204, or structures having more than two-plates.

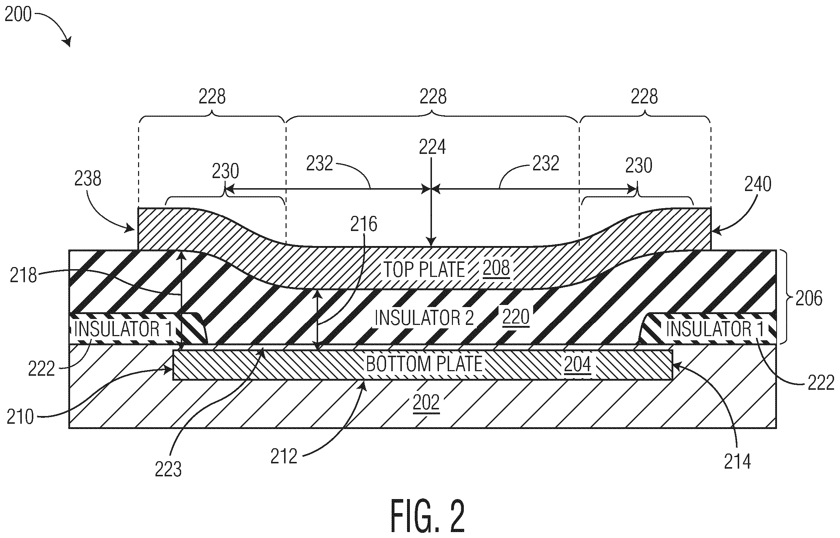

Figure 2 represents a first example 200 of a capacitance device having a curved topology. The first example 200 capacitance device includes a substrate 202, a bottom-plate 204, an insulator 206, and a top-plate 208. The bottom-plate 204 is coupled to the substrate, the insulator 206 is coupled to the bottom-plate 204, and the top-plate is coupled to the insulator 206. The capacitance device 200 may also include an additional insulating layer 223 (e.g., passivation layer) immediately on top of the bottom plate 204.

In various example embodiments, the top-plate 208 and the bottom-plate 204 can be made of aluminum or another conductive (e.g. metal) layer, and the insulator 206 can be made of oxide, nitride, polyimide or another insulating material. The capacitance device 200 may be fabricated either separately or within a semiconductor device.

The insulator 206 has a first distance/thickness 216 and a second distance/thickness 218. The insulator 206 includes a first dielectric material (insulator 2) 220, and a second dielectric material (insulator 1) 222.

The top-plate 208 has a center 224, a flat portion 226, a curved portion 228, a first end 238, and a second end 240.

The flat portion 226 of the top-plate 208 starts at a center 224 of the top-plate 208 and ends at the curved portion 228 of the top-plate 208.

The curved portion 228 includes an upwards curved portion (e.g. an S-bend) 230 at a first distance 232 from the center 224, and possibly extended flat portion onto the location of the second distance/thickness 218. The upwards curved portion 230 defines a bend in the top-plate 208.

The flat portion 226 of the top-plate 208 is at a first distance 216 from the bottom-plate 204. The curved portion 228 of the top-plate 208 is at a second distance 218 from the bottom-plate 204. The second distance 218 is greater than the first distance 216. Thus the insulator 206 has a first thickness 216 under the flat portion 226 of the top-plate 208, and a second thickness 218 under the curved portion 228 of the top-plate 208.

The bottom-plate 204 includes a first end 210, a middle area 212, and a second end 214. The first end 210 is at one side of the middle area 212 and the second end 214 is at another side of the middle area 212.

The insulator 206 includes the second dielectric material (insulator 1) 222 at the first end 210 and second end 214 of the bottom-plate 204. The insulator 206 also includes the first dielectric material (insulator 2) 220 that overlays the second dielectric material (insulator 1) 222, the first end 210, the middle area 212, and the second end 214 of the bottom-plate 204.

The first dielectric material (insulator 2) 220 and the second dielectric material (insulator 1) 222 may be a same or different dielectric materials, just as long as they create the first distance/thickness 216 and the second distance/thickness 218.

The thickness 216 of the insulator 206 at the center 224 of the top-plate 208 is thinner than the thickness 218 of the insulator 206 at the edges 238, 240 since the edges 238, 240 of the top-plate 208 are raised up. This improves the dielectric breakdown performance due to thicker 218 material while maintaining the device's 200 capacitance due to the thinner 216 layer.

Thus any decrease in capacitance due to the greater insulator 206 thickness at the ends 238, 240 can be compensated by making the insulator 206 thinner at the center 224 to meet a device application's functional specifications, but still sufficiently thick enough to be manufacturable through the package and assembly processes, especially the wire-bond process.

While in this example 200 embodiment, the insulator 206 under the top-plate 208 includes two insulator 206 layers (i.e. the first dielectric material (insulator 2) 220, and the second dielectric material (insulator 1) 222). In other example embodiments, the insulator 206 under the top-plate 208 may include more than two insulator 206 layers.

Also, by varying the thickness of either the first dielectric material (insulator 2) 220, or the second dielectric material (insulator 1) 222, a radius of the upwards curved portion (e.g. S-bend) 230 of the top-plate 208 can also be controlled (can see Figure 2 to Figure 4).

The overall size and shape of the top-plate 208 does not need to match or be larger or small than the bottom-plate 204. In other words the two plates 204, 208 do not need to be symmetric.

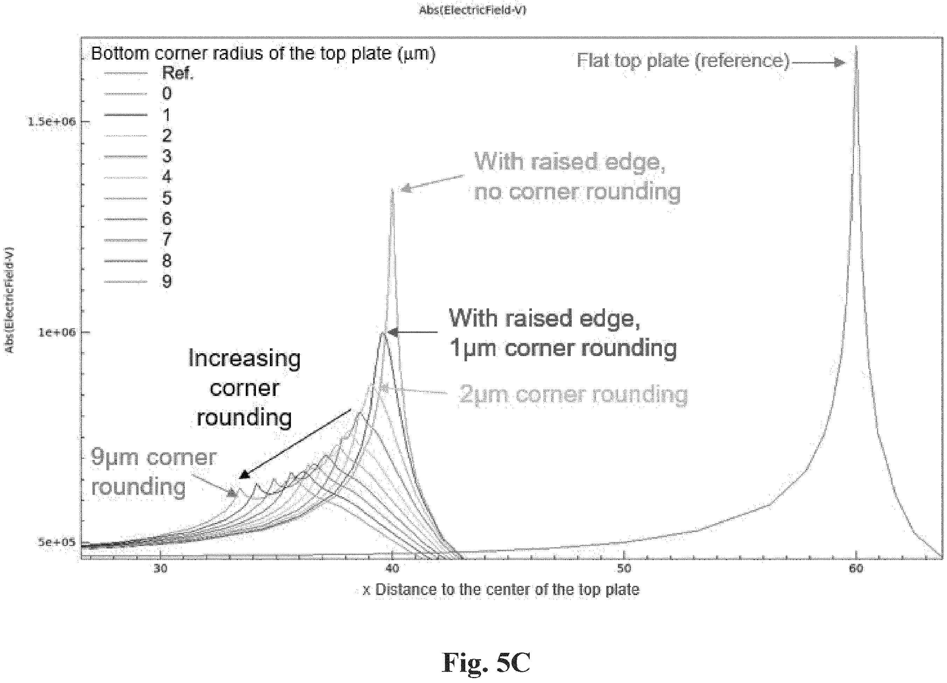

These raised and/or curved portions 230 of the top-plate 208 significantly reduce a peak electric field magnitude of the capacitance device 200 during operation (see Figures 5B and 5C).

Thus the capacitance device 200 has a designated top-plate 208 topology that has both raised curved portions 230 (i.e. a greatest thickness at the edges 238, 240) to improve high voltage isolation and dielectric breakdown performance, as well as a smaller thickness in the center 224 of the top-plate 208 to maximize capacitance and meet the device application's functional performance.

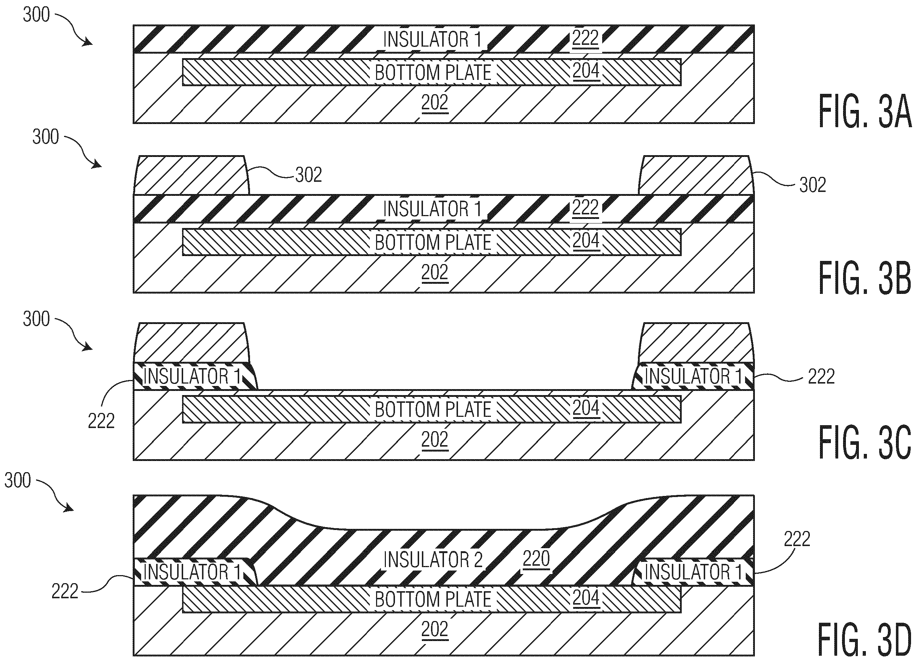

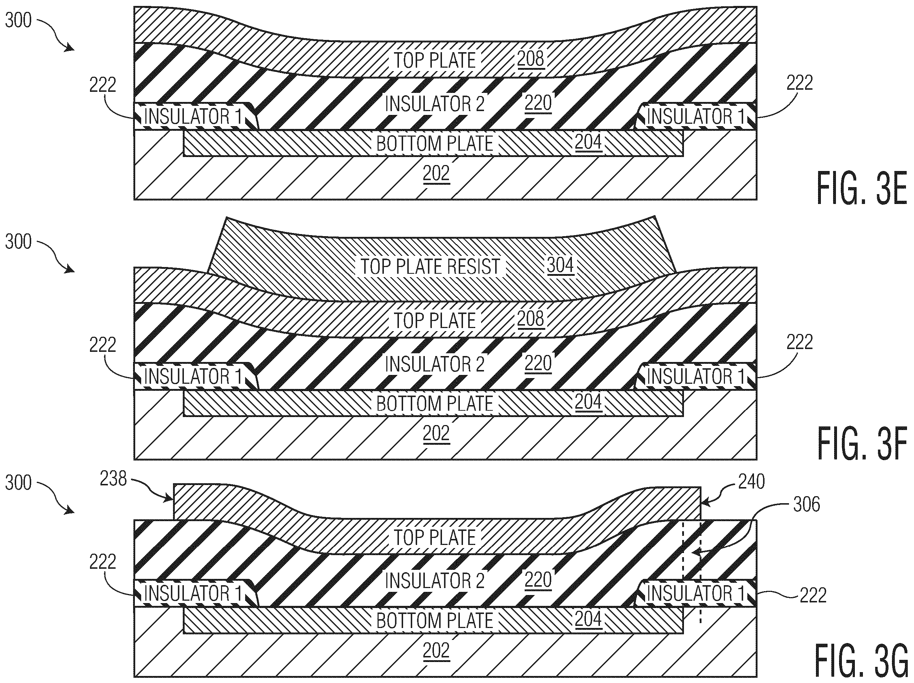

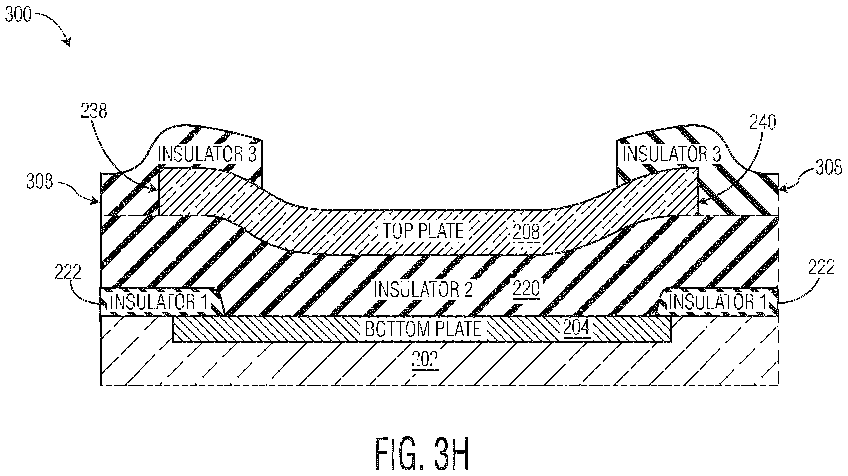

Figures 3A, 3B, 3C, 3D, 3E, 3F, 3G, 3H represent an example 300 set of steps for fabricating the first example capacitance device 200.

Figure 3A - 1st insulating layer deposition. Figure 3B - Patterning of 1st insulating layer deposition using a first photoresist mask 302. Figure 3C - 1st Insulating layer etch. Figure 3D - 2nd insulating layer deposition. Note, in some example embodiments, instead of adding two insulators 220, 222 as shown in the example 300, insulator 1 (i.e. 222) is only partially etched to create an indented surface and thus the different first distance/thickness 216 and second distance/thickness 218.

Next in Figure 3E - Top-plate 208 deposition. Figure 3F - Top-plate 208 patterning. Figure 3G - Top-plate 208 etch. Some overhang 306 is good, but not essential. Figure 3H - An additional dielectric material (insulator 3) 308 can be deposited, patterned and etched as desired to buttress/protect the top-plate 208 edges 238, 240. The additional dielectric material (insulator 3) 308 helps protect against lateral forces that can lead to top-plate 208 delamination, and/or protect against ingress of contamination from molding compound applied in a later encapsulation step (not shown).

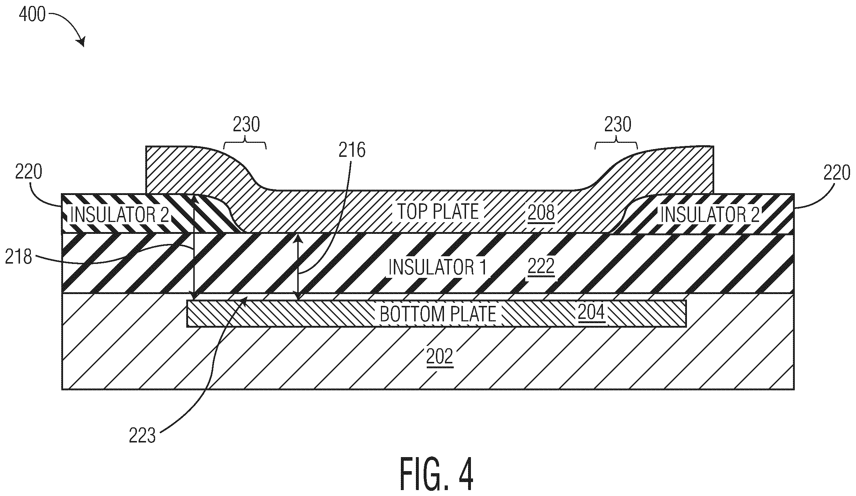

Figure 4 represents a second example 400 of the capacitance device having a curved topology. The second example 400 of the capacitance device shows an alternate way to generate curved portions 228 of the top-plate 208 (e.g. raised edges and a flat surface in the center).

The second example capacitance device 400 is substantially the same as the first example capacitance device 200 except the fabrication of the first distance/thickness 216 and the second distance/thickness 218 using the first dielectric material (insulator 2) 220 and the second dielectric material (insulator 1) 222 has changed.

In this example 400, the upwards curved portion (e.g. an S-bend) 230 in the top-plate 208 is sharper than in the first example 200 of the capacitance device (see Figure 2). Thus by varying the thickness of the insulator 2, the radius of the bottom corner of the top-plate 208 can in some example embodiments be better controlled.

Figures 5A, 5B, 5C represent an example set of simulations 500 comparing the prior art capacitor 100 (see Figure 5A) with the example capacitance devices 200, 400 (see Figure 5B). The lines in the Figures 5A and 5B show electrostatic potential (V) contours.

Figure 5C shows electric field magnitudes (y-axis) for both the prior art capacitor 100 and the capacitance devices 200, 400 along a cutline 502 that is about 0.1µm below the top-plate 208 in both Figures 5A and 5B. The electric field magnitudes (y-axis) for the capacitance devices 200, 400 show varying amounts of corner-rounding in the upwards curved portion 230.

Raising the edge of the top conducting plate clearly reduces the magnitude of the electric field peak at the bottom corner of the top-plate 208. Increasing the radius of the bottom corner further decreases the electric field peak. Thus a maximum value of the electric field strength (y-axis) is reduced using the present capacitance device example embodiments, and thus reducing a chance of dielectric breakdown during operation.

In this specification, example embodiments have been presented in terms of a selected set of details. However, a person of ordinary skill in the art would understand that many other example embodiments may be practiced which include a different selected set of these details. It is intended that the following claims cover all possible example embodiments.

It will be readily understood that the components of the embodiments as generally described herein and illustrated in the appended figures could be arranged and designed in a wide variety of different configurations. Thus, the detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its spirit or essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

## Claims

1. A capacitance device, comprising:
a substrate;
a bottom-plate coupled to the substrate;
an insulator coupled to the bottom-plate; and
a top-plate coupled to the insulator;
wherein the top-plate includes a flat portion and a curved portion.

2. The capacitive device of claim 1:
wherein the substrate is a semiconductor or an insulator.

3. The capacitive device of claim 1 or 2:
wherein the curved portion of the top-plate is at a first end of the flat portion of the top-plate.

4. The capacitive device of claim 3:
wherein the curved portion of the top-plate is also at a second end of the flat portion of the top-plate.

5. The capacitive device of any preceding claim:
wherein the curved portion of the top-plate surrounds the flat portion of the top-plate.

6. The capacitive device of any preceding claim:
wherein the flat portion of the top-plate starts at a center of the top-plate and ends at the curved portion of the top-plate.

7. The capacitive device of any preceding claim:
wherein the curved portion of the top-plate includes an upwards curved portion.

8. The capacitive device of claim 7:
wherein the upwards curved portion is at a predetermined distance from the center of the top-plate.

9. The capacitive device of claim 8:
wherein the upwards curved portion defines a bend in the top-plate.

10. The capacitive device of any preceding claim:
wherein the flat portion of the top-plate is at a first distance from the bottom-plate; and
wherein the curved portion of the top-plate is at a second distance from the bottom-plate.

11. The capacitive device of claim 12:
wherein the second distance is greater than the first distance.

12. The capacitive device of any preceding claim:
wherein the insulator has,
a first thickness under the flat portion of the top-plate; and
a second thickness under the curved portion of the top-plate.

13. The capacitive device of any preceding claim:
wherein the bottom-plate includes a first end, a middle area, and a second end; and
wherein the first end is at one side of the middle area and the second end is at another side of the middle area.

14. The capacitive device of claim 13:
wherein the insulator includes a first insulator portion at the first end of the bottom-plate; and
wherein the insulator also includes a second insulator portion that overlays the first insulator portion, the first end, the middle area, and the second end of the bottom-plate.

15. The capacitive device of claim 14:
wherein the first insulator portion is also at the second end of the bottom-plate.
